# EUROPÄISCHE PATENTSCHRIFT

(11) **EP 1 576 864 B1**
(45) Veröffentlichungstag und Bekanntmachung des Hinweises auf die Patenterteilung: **05.07.2006**
(21) Anmeldenummer: 03779556.4
(22) Anmeldetag: 29.12.2003
(51) Int. Cl.: H05K 3/46, B32B 37/00

(54) **TRENNPLATTE ZUM HERSTELLEN VON LEITERPLATTENKOMPONENTEN**
SEPARATOR PLATE FOR THE PRODUCTION OF CIRCUIT BOARD COMPONENTS
PLAQUE SEPARATRICE DESTINEE A ETRE UTILISEE POUR PRODUIRE DES COMPOSANTS DE CARTES DE CIRCUITS IMPRIMES

(30) Priorität: 27.12.2002 AT 19372002
(43) Veröffentlichungstag der Anmeldung: 21.09.2005
(73) Patentinhaber: C2C Technologie für Leiterplatten GmbH, 8700 Leoben-Hinterberg (AT)
(72) Erfinder: BACKHAUS, Ernst-Dieter, 79350 Sexau (DE)
(74) Vertreter: Sonn & Partner Patentanwälte
(86) Internationale Anmeldenummer: PCT/AT2003/000389
(87) Internationale Veröffentlichungsnummer: WO 2004/060036

(56) Entgegenhaltungen:
- EP-A- 0 453 629
- US-A- 3 778 238
- US-A- 4 264 030
- US-A- 5 256 474
- US-A- 6 130 000
- US-A1- 2002 124 938
- US-B1- 6 329 077
- PATENT ABSTRACTS OF JAPAN vol. 1999, no. 11, 30. September 1999 (1999-09-30) & JP 11 170382 A (SHIN KOBE ELECTRIC MACH CO LTD), 29. Juni 1999 (1999-06-29)

## Beschreibung

Die Erfindung betrifft eine Trennplatte zum Herstellen von Leiterplattenkomponenten unter Verpressen von Einzellagen gemäß dem einleitenden Teil von Anspruch 1. Eine solche Trennplatte ist aus EP 453 629 A bekannt. Im Einzelnen wird dabei eine Metallschicht an einer Seite in einem Plattierband mit einer vergleichsweise härteren Beschichtung versehen.

Zur Herstellung von aus mehreren Lagen gebildeten Leiterplattenkomponeten, insbesondere von sogenannten Multilayer-Leiterplatten oder kurz Multilayers, ist es bekannt, Einzellagen-Presspakete in entsprechenden Etagen- oder Vakuumpressen bei einer Temperatur von z.B. ca. 180°C miteinander zu verbinden. Die einzelnen Anordnungen bestehen aus Kupferfolien, die zur Herstellung der Leiterbahnen erforderlich sind, sowie aus Kunstharzschichten (Prepreg-Schichten, üblicherweise Epoxidharz-Schichten) bzw. Laminatschichten. Eine der Multilayer-Leiterplatten-Herstellung vergleichbare Herstellung ist bei den sogenannten Basismaterialien für Leiterplatten denkbar, bei denen es sich üblicherweise um eine Kunstharzschicht (Prepreg-Schicht) handelt, die einseitig oder beidseitig mit einer leitenden Schicht (insbesondere einer Kupferfolie) kaschiert ist. Diese Basismaterialien werden auch als sogenannte "Innenlagen" bei der Herstellung von Multilayer-Leiterplatten verwendet und bilden für sich ebenfalls Leiterplattenkomponenten.

In der Regel werden beim Verpressen wie oben angeführt mehrere Presspakete übereinander in einer Presse angeordnet, und diese Pakete werden durch Trennplatten, auch Pressplatten genannt, voneinander getrennt. Die Trennplatten haben vor allem die Aufgabe, eine einheitliche Druck- und Temperaturverteilung beim Pressen der Einzellagen herbeizuführen, um so qualitativ hochwertige Leiterplattenprodukte zu erzielen. Die Trennplatten bestehen zumeist aus einem Stahlblech oder aber aus Aluminiumblech und werden deshalb auch Trennbleche genannt. Aufgrund der beschriebenen Funktion sollen sie härter sein als die Kupferfolien. Diese Anforderung ist umso bedeutsamer, wenn bedacht wird, dass bei modernen Leiterplatten die Leiterbahnen immer schmäler werden, und auch ihre Abstände immer kleiner werden. Beispielsweise werden bei sog. High Tech-Leiterplatten nach der HDI-Technologie (HDI-High Density Interconnect-Technologie) Kupferfolien mit Dicken von < 12 µm, beispielsweise bloß 5 µm, verwendet. Dabei ist die Gefahr gegeben, dass sich die Leiterbahnen beim Verpressen durch die äußeren Kupferfolien in den Presspaketen durchdrücken können, welcher Effekt als "Imagetransfer" bezeichnet wird. Um diesen Imagetransfer auf kostengünstige Weise zu vermeiden, werden daher in der Multilayer-Technologie zumeist Edelstahlbleche, beispielsweise mit einer Dicke von 1,5 mm oder 1,2 mm, als Trennplatten eingesetzt, da diese Edelstahlbleche eine große Oberflächenhärte aufweisen und überdies, wie dies ebenfalls aus Kostengründen erwünscht ist, wiederholt verwendet werden können.

Andererseits ist jedoch Edelstahl ein vergleichsweise schlechter Wärmeleiter, wobei gerade bei den vorerwähnten HDI-Leiterplatten mit den immer kleineren Leiterbahn-Breiten und -Abständen eine besonders schnelle und gleichmäßige Wärmeverteilung über die Fläche der einzelnen Lagen wie auch über die gesamte Höhe oder Dicke des zu verpressenden Stapels wichtig ist, um eine entsprechende Qualität zu sichern. Bekannte Trennplatten mit einer besseren Wärmeleitfähigkeit bestehen demgemäß insbesondere aus Aluminium (bzw. einer Aluminium-Legierung; wenn nachstehend Aluminium erwähnt wird, so ist hierunter auch immer eine Aluminium-Legierung zu verstehen), vgl. beispielsweise US 5 153 050 A. Aluminiumbleche als Trennplatten haben jedoch im Vergleich zu Edelstahl-Trennplatten eine wesentlich geringere Oberflächenhärte, und sie weisen z.B. lediglich eine Streckgrenze in der Höhe von ca. 40% der Streckgrenze von Edelstahl auf. Hinzu kommt, dass Aluminium gerade bei der Presstemperatur, bei ca. 180°C bis 200°C, ungefähr 25% seiner Festigkeit (Streckgrenze) verliert und "weichgeglüht" wird. Auch hierdurch kommt es zum vorerwähnten Imagetransfer. Bei der Presstemperatur von 180°C oder 200°C ändert sich bei Edelstahl-Trennplatten hingegen die Festigkeit oder Oberflächenhärte praktisch noch nicht.

Ein weiterer Nachteil von Aluminium-Trennplatten ist darin zu sehen, dass Aluminium im Vergleich zu den meisten anderen hier in Frage kommenden Metallen einen hohen Wärmeausdehnungskoeffizienten hat. Dadurch ergibt sich beim Pressen wie vorstehend erwähnt, insbesondere nach Verflüssigung des Epoxidharzes, eine Verschiebung der einzelnen zu verpressenden Lagen im Presspaket, wenn sich die Aluminium-Trennplatten ausdehnen, und dies kann insbesondere bei den erwähnten Leiterzugbreiten im Mikrometerbereich, und zwar bereits bei Breiten von z.B. 100 µm und darunter, zu Schäden und somit zum Ausschuss führen.

Die vorstehend im Zusammenhang mit Aluminium-Trennplatten angeführten Nachteile gelten in vergleichbarer Weise für Trennplatten, die aus Kupfer hergestellt werden. Kupfer wäre ein ausgezeichneter Wärmeleiter und würde so die schnelle und gleichmäßige Wärmeverteilung im Pressstapel sicherstellen, jedoch kann Kupfer bei weitem nicht die Kriterien hinsichtlich Festigkeit bzw. Oberflächenhärte, zur Vermeidung des angeführten Imagetransfers, erfüllen.

Eine Trennplatte aus Aluminium ist im Übrigen beispielsweise auch aus der US 5 256 474 A bekannt, wobei bei dieser Trennplatte überdies an der Aluminium-Kernschicht eine Antihaftschicht auf beiden Seiten aufgebracht ist, um nach dem Verpressen die Trennplatte leichter von den Kupferlagen der Leiterplatten lösen zu können. Es handelt sich jedoch auch hier um eine Aluminiumblech-Trennplatte mit den vorstehend erwähnten Nachteilen.

Aus der WO 99/53737 A und der WO 02/058448 A sind andererseits Trennplatten mit einem Substrat aus einer Stahllegierung bekannt, auf dem gemäß WO 99/53737 A weiters zumindest eine Kupferlage aufgebracht ist; diese Kupferlage hat jedoch wie dargelegt eine niedrige Oberflächenhärte, und die Kernschicht, d.h. das Substrat, hat eine niedrige Wärmeleitfähigkeit; dieser Nachteil ist auch bei der Trennplatte gemäß der WO 02/058448 A gegeben, wobei dort metallische Zwischenschichten, insbesondere aus Aluminium, vorgesehen sind, welche äußere Metallschichten, insbesondere aus Kupfer, mit dem Stahl-Substrat verbinden; diese äußeren Metallschichten, insbesondere Kupferschichten, werden in die herzustellenden elektrischen Komponenten eingebaut, sind also überdies genau genommen nicht Teil der eigentlichen Trennplatte.

Es ist nun Aufgabe der Erfindung, eine Trennplatte wie eingangs angeführt vorzusehen, mit der den erwähnten, aufgrund der zusammenhängenden Materialeigenschaften einander widersprechenden Anforderungen betreffend gleichmäßige Wärmeverteilung einerseits und hohe Festigkeit bzw. Oberflächenhärte andererseits in zufriedenstellender Weise entsprochen werden kann. Die Erfindung basiert dabei auf der Überlegung, die Trennplatten als Verbundwerkstoff-Trennplatten auszuführen und so die Eigenschaften verschiedener Metalle in Kombination vorzusehen und zu nutzen.

Zur Lösung dieser Aufgabe sieht die Erfindung eine Trennplatte mit den Merkmalen des unabhängigen Anspruches vor. Vorteilhafte Ausführungsformen und Weiterbildungen sind in den Unteransprüchen definiert.

Bei der erfindungsgemäßen Trennplatte liegt somit eine Kernschicht oder Mittelschicht aus einem hoch wärmeleitfähigen Metall wie Aluminium oder Kupfer vor, und diese Kernschicht wird beidseitig durch Kaltplattieren bzw. Walzplattieren mit einem harten Metall, wie z.B. Edelstahl, Kohlenstoffstahl, aber auch Nickel oder dergl., verbunden. Diese Hartmetallplattierung kann dabei vergleichsweise dünn sein, beispielsweise in der Größenordnung von ca. 0,075 mm dick sein, wogegen der Kern, z.B. aus Aluminium oder Kupfer, beispielsweise eine Dicke von 0,35 mm aufweist. Beim Walzplattieren bzw. Kaltplattieren erfolgt eine flächige Verbindung der Metalle in der Art einer Verschmelzung, wobei sich auch als vorteilhafter Effekt ergibt, dass bei einer Erwärmung die Wärmeausdehnung nur entsprechend jener der Hartmetallplattierung erfolgen kann, d.h. es kommt nicht mehr zu den verhältnismäßig starken-Wärmeausdehnungen der wärmeleitfähigen Metalle wie Aluminium oder Kupfer, wenn diese Metalle allein für die Trennplatte verwendet werden. Hinzu kommt, dass die Wärmedehnung, beispielsweise von Stahl, die von Haus aus wesentlich geringer ist als jene von Aluminium, erst bei einer vergleichsweise hohen Temperatur zum Tragen kommt, diese hohe Temperatur aber beim gegenständlichen Verpressen von Einzellagen zur Herstellung von Leiterplattenkomponenten nicht auftritt. Beispielsweise würden Aluminium-Trennplatten in einer Größe von 600x450 mm eine Dehnung um ca. 5 mm in jeder Richtung erfahren, eine Trennplatte aus Stahl mit diesen Abmessungen an sich - jedoch erst bei hohen Temperaturen - nur eine Dehnung um ca. 2 mm, jedoch erst bei höheren Temperaturen, bei den fraglichen Temperaturen von 180°C oder 200°C beim Verpressen hingegen nur im Ausmaß von 0,1 mm - 0,2 mm. An diese geringe Dehnung muss sich zwangsläufig aufgrund der Verschmelzung mit dem harten Plattierungsmaterial auch die Kernschicht aus wärmeleitfähigem Metall angleichen.

Ein weiterer Vorteil der erfindungsgemäßen Trennplatte liegt darin, dass trotz der Herstellung als Verbundplatte niedrige Kosten auch deshalb erzielt werden können, da Aluminium ein relativ niedriges spezifisches Gewicht hat, so dass sich der pro Kilogramm zu berechnende Einkaufspreis für Aluminium relativ gering im Verkaufspreis für die Trennplatten niederschlägt, der nach der Fläche der Trennplatten berechnet wird.

Insgesamt wird durch die Erfindung somit eine Trennplatte erhalten, die einerseits aufgrund der guten Wärmeleitfähigkeit des hiefür maßgeblichen Kerns (bezogen auf die Gesamtmasse der Trennplatte liegen ca. 75% wärmeleitfähiges Material, z.B. Aluminium, und nur 25% Hartmetall, z.B. Stahl, vor) eine gleichmäßige Wärmeverteilung über die Fläche und die Stapelhöhe beim Verpressen sicherstellt, d.h. das Epoxidharz wird bei Verwendung der erfindungsgemäßen Trennplatten praktisch überall auf einmal flüssig, und die andererseits durch das aufplattierte Hartmetall die erforderliche Oberflächenhärte besitzt, um den unerwünschten Imagetransfer zu vermeiden, und um auch eine oftmalige Verwendung der Trennplatte in Verpressvorgängen zu ermöglichen. Zum Verpressen ist es dabei auch mit Vorteil möglich, auf der äußeren, harten Metallschicht ein Gleitmittel, wie z.B. ein Gleitmittel auf Olefinbasis, aufzubringen.

Die Erfindung wird nachstehend anhand eines in der Zeichnung dargestellten, besonders vorteilhaften Ausführungsbeispiels, auf das sie jedoch nicht beschränkt sein soll, noch weiter erläutert. Es zeigen im Einzelnen:
Fig. 1 in einer schematischen Ansicht einen Aufbau eines Multilayer-Presspakets mit mehreren Einzellagen und Trennplatten-Verbundkomponenten;
Fig. 2 schematisch in einer Ansicht eine Trennplatten-Verbundkomponente mit einem Trennfoliensack;
Fig. 3 eine schematische Draufsicht auf eine derartige Trennplatten-Verbundkomponente gemäß Fig. 2; und
Fig. 4 einen schematischen Schnitt durch eine Trennplatte, wie sie in den Anordnungen von Fig. 1 bis 3 verwendet werden kann, und wie sie Gegenstand der vorliegenden Erfindung ist.

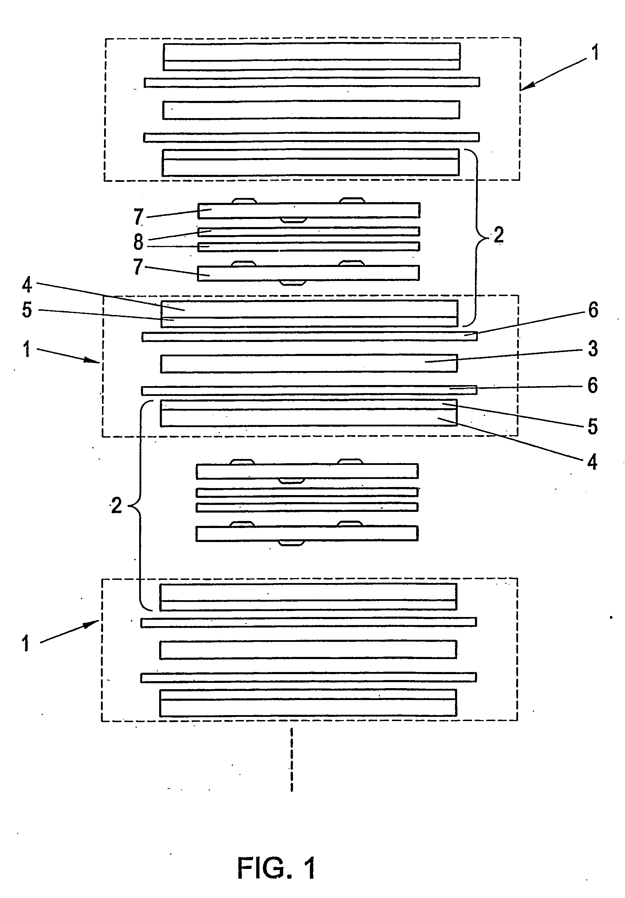

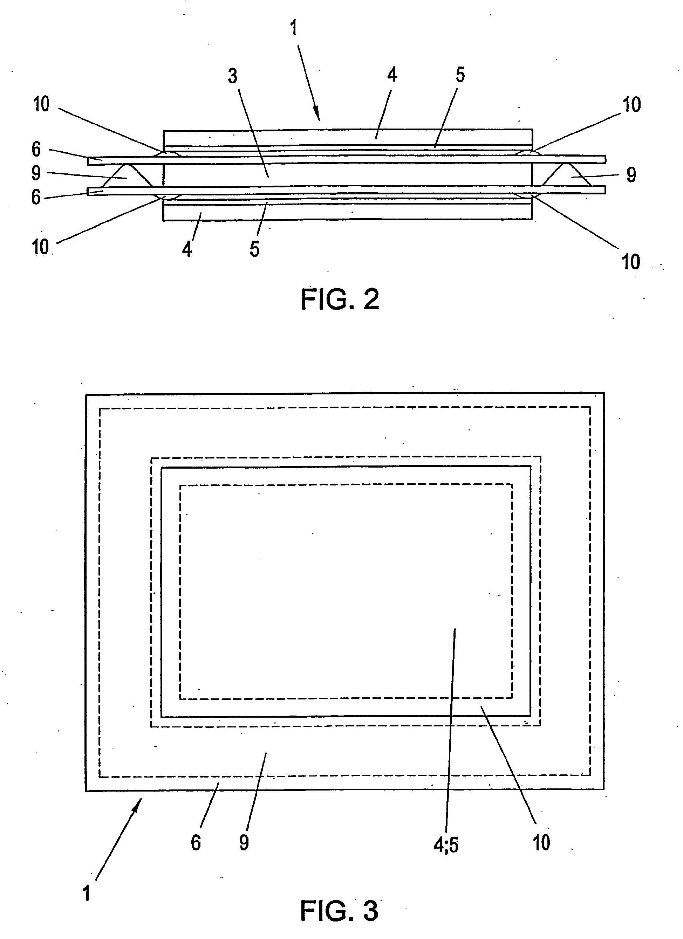

In Fig. 1 ist ein Multilayer-Presspaket schematisch und ausschnittsweise gezeigt, wobei ersichtlich ist, dass Trennplatten-Verbundkomponenten 1 mit Einzellagen-Anordnungen 2 für Multilayer-Leiterplatten, nachstehend kurz Anordnungen 2 genannt, abwechseln. Die mit strichlierten Rechtecken veranschaulichten Trennplatten-Verbundkomponenten 1 weisen je eine Trennplatte 3, auch Pressplatte, Trennblech oder Pressblech genannt, auf, an der mit einer Harzschicht 4 versehene Kupferfolien 5 über Antihaftlagen 6, hier in Form von Trennfolien, angebracht werden. Die gesamte Einheit mit harzbeschichteter Kupferfolie 5, 4, Trennfolie 6, Trennblech 3, neuerlich Trennfolie 6 und mit Kunstharz 4 beschichtete Kupferfolie 5, wird im Vorhinein zur Verbundkomponente 1 zusammengefügt, wie dies nachstehend anhand der Figuren 2 und 3 in einem Ausführungsbeispiel näher erläutert werden wird.

Die mit Harz 5 beschichteten Kupferfolien 4 der Verbundkomponenten 1 werden Bestandteil der Multilayer-Leiterplatten, zu denen weiters geätzte Innenlagen 7 (Basismaterialien) und Kunstharzschichten (Prepreg-Schichten) 8 der Anordnungen 2 gehören.

Dadurch, dass derartige Trennplatten-Verbundkomponenten 1 als Einheiten vorgesehen und beim Herstellen der Leiterplatten(komponenten) abwechselnd mit den Multilayer-Einzellagen übereinander gestapelt werden können, wird das Stapeln in der Presse wesentlich vereinfacht, da fünf Komponenten - 4/5;6;3;6;5/4 - in einem einzigen Vorgang auf einmal gelegt werden können. Dies reduziert die Handlingzeit wesentlich. Die geätzten Innenlagen 7 realisieren die gewünschte Schaltung bzw. Leiterstruktur, und sie werden mit Hilfe der Prepreg-Schichten 8 miteinander verklebt. Dieses Verbinden erfolgt in einer Presse bei erhöhter Temperatur (z.B. bei 180°C) sowie bei Druck oder aber Vakuum. In einem solchen Presspaket, wie es schematisch zum Teil in Fig. 1 veranschaulicht ist, können durchaus 20 Anordnungen 2 übereinander geschichtet sein. Zwischen den einzelnen Anordnungen 2 werden die Trennblech-Verbundkomponenten 1 gelegt, wobei die Trennbleche 3 für eine glatte, saubere Oberfläche der hergestellten Multilayer-Leiterplatten sorgen.

Während des definierten Presszyklus beginnt das Kunstharz der Prepreg-Schichten 8 zu fließen. Dadurch, dass die Antihaftlagen oder Trennlagen 6 vorgesehen sind, wird verhindert, dass das Harz der Schichten 8 auf die Trennbleche oder allgemein Trennplatten 3 gelangt, und es wird auch verhindert, dass das Harz zu den Kanten der Trennplatten 3 fließt.

Gemäß Fig. 2 und 3 sind gesonderte Trennfolien als Antihaftlagen 6 vorgesehen, und diese Trennfolien 6 sind größer als die Trennplatte 3 und auch größer als die Kupferfolien 5 mit den Harzschichten 4. Wie aus Fig. 2 ersichtlich, sind in diesem Fall die Kupferfolien 5 und die Trennplatte 3 bevorzugt gleich groß, auch wenn die Kupferfolien 5 geringfügig kleiner sein können als die Trennplatte 3. Da die Trennfolien 6 allseitig über die Trennplatte 3 vorstehen, kann so das flüssige Harz gefangen werden. Damit das Harz auch nicht zwischen den Trennfolien 6 zur Trennplatte 3 gelangen kann, sind die Trennfolien 6 miteinander längs einer Klebenaht 9 mit Hilfe eines druckempfindlichen Klebers, eines Acrylatklebers bzw. eines Schmelzklebers verbunden. Dadurch ist die Trennplatte 3 zwischen den sackartig miteinander verbundenen Trennfolien 6 eingeschlossen, das heißt die Trennplatte 3 liegt in einem Trennfoliensack vor, wobei sie in diesem Trennfoliensack frei beweglich angeordnet ist.

Die Kupferfolien 5 sind andererseits ebenfalls mit Hilfe von Klebern, z.B. Schmelzklebern, insbesondere Heißschmelzklebern, oder Acrylatklebern, in der Art einer Klebenaht 10 an den Trennfolien 6 angeklebt.

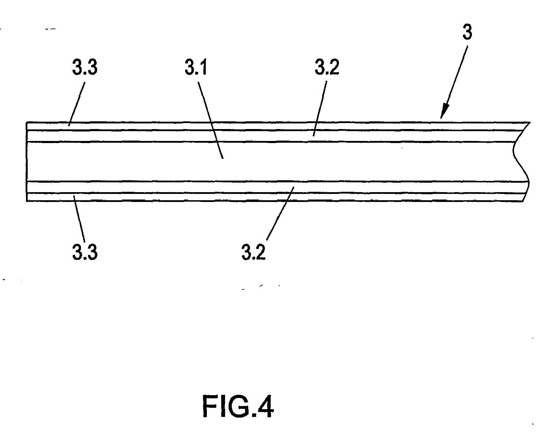

In Fig.4 ist nun ein schematischer Querschnitt der besseren Darstellung wegen (ohne Schraffuren) durch eine Trennplatte 3 gezeigt, die einen speziellen, neuartigen Verbund-Aufbau aufweist. Im Einzelnen ist eine Mittelschicht oder Kernschicht 3.1 aus einem hoch-wärmeleitfähigen Metall, wie beispielsweise Aluminium oder aber auch Kupfer, vorgesehen, und diese Kernschicht 3.1 ist beidseitig außen durch Walzplattieren, allgemein Kaltplattieren, mit einer äußeren Metallschicht 3.2 verbunden, die aus einem im Vergleich zur Kernschicht 3.1 harten Metall besteht, wie beispielsweise aus Edelstahl, Kohlenstoffstahl, aber auch Nickel oder dergl. Metall. Beim Aufbringen dieser äußeren, harten Metallschichten 3.2 auf der Kernschicht 3.1 durch Kaltplattieren wird eine Verschmelzung der beiden Metalle herbeigeführt, so dass sich eine feste, flächige Verbindung ergibt. Diese feste, flächige Verbindung führt bei der fertigen Trennplatte 3 dazu, dass sich die Kernschicht 3.1 aus dem vergleichsweise (also relativ zu den äußeren Metallschichten 3.2) gut wärmeleitenden Metall nicht mehr in einem derartigen Ausmaß dehnen kann, wenn sie erwärmt wird, wie in dem Fall, wenn sie frei vorliegt, d.h. es ergibt sich insgesamt eine Wärmedehnung entsprechend jener der äußeren Metallschichten 3.2 aus hartem Metall.

In einem Beispiel wurde eine Trennplatte 3 mit einer Kernschicht 3.1 aus Aluminium mit einer Dicke von ungefähr 0,35 mm vorgesehen, welche beidseitig mit einer äußeren Metallschicht aus Edelstahl, mit einer Dicke von ca. 0,075 mm, versehen wurde. Es ergibt sich dabei zwar eine kombinierte Wärmeleitfähigkeit, die etwas geringer ist als jene von Aluminium (bzw. der Aluminiumlegierung) allein, jedoch liegt diese kombinierte Wärmeleitfähigkeit durchaus in der Größenordnung von jener von Aluminium, etwa bei 170 W/m . K im Vergleich zu 210 W/m . K. Die kombinierte Wärmedehnung dieser Verbund-Trennplatte 3 entspricht andererseits im Wesentlichen jener von Stahl, insbesondere Edelstahl oder aber Kohlenstoffstahl, d.h. sie beträgt beispielsweise nur 1/25 bis 1/50 der Wärmedehnung von Aluminium allein.

Ein anderes konkretes Beispiel, dass sich bei praktischen Tests besonders bewährt hat, hat bei einer Trennplatten-Gesamtdicke von 0,5 mm beispielsweise folgenden Aufbau:
0,05 mm Edelstahl (oder Stahl)
0,40 mm Aluminium
0,05 mm Edelstahl (oder Stahl)

Es ergeben sich daher folgende physikalische Werte, anhand derer die Bedeutung der vorliegenden Verbund-Trennplatte deutlich wird:

| | Aluminium | Edelstahl | Verbundwerkstoff (Trennplatte) |
|---|---|---|---|
| Festigkeit/Oberflächen-härte in Mpa | ca. 240 | ca. 800 | ca. 800 |
| Wärmeleitfähigkeit in W / m.K | 210 | 25 | 170 |
| Wärmeausdehnung in 10⁻⁶.K⁻¹ | 23,5 | 10,5 | 10,5 |

Aus Fig.4 ist noch ersichtlich, dass die Verbund-Trennplatte 3 noch mit äußeren Gleitmittel-Beschichtungen 3.3 auf beiden Seiten oder Oberflächen versehen sein kann, wobei diese Gleitmittel-Beschichtungen in an sich bekannter Weise auf einer Olefinbasis vorgesehen sein können.

Eine derartige Verbund-Trennplatte 3 mit den unterschiedlichen Metallen kann in einer Trennplatten-Verbundkomponente wie vorstehend anhand der Fig.1 bis 3 beschrieben verwendet werden, sie kann jedoch selbstverständlich auch in Presspaketen in einer Einzelanordnung, wie dies aus dem Stand der Technik, etwa gemäß US 5 356 474 A, an sich bekannt ist, in gleicher Weise eingesetzt werden. Da wie dort erbringt die vorliegende Verbund-Trennplatte 3 im Besonderen den Vorteil der Kombination der einander eigentlich widersprechenden Effekte der hohen Festigkeit und Oberflächenhärte einerseits sowie der guten Wärmeleitfähigkeit andererseits, um beim Verpressen von Einzellagen zur Herstellung von Leiterplattenkomponenten ein rasches, gleichmäßiges Verflüssigen des Epoxidharzes sicherzustellen sowie einen Imagetransfer bzw. Beschädigungen der Oberfläche hintanzuhalten und auch Wiederverwendungen der Trennplatte 3 sicherzustellen.

## Patentansprüche

1. Trennplatte (3) zum Herstellen von Leiterplattenkomponenten unter Verpressen von Einzellagen, welche Trennplatte (3) eine metallische Kernschicht (3.1) und eine Beschichtung aus einem Metall aufweist, das im Vergleich zur metallischen Kernschicht (3.1) eine große Oberflächenhärte aufweist, **dadurch gekennzeichnet, dass** die Beschichtung an beiden Seiten der Kernschicht (3.1) aus durch Kaltplattieren auf die Kernschicht aufgebrachten äußeren Metallschichten (3.2) besteht, wobei die metallische Kernschicht (3.1) aus einem im Vergleich zu den beiden äußeren Metallschichten (3.2) gut wärmeleitenden Metall besteht.

2. Trennplatte nach Anspruch 1, **dadurch gekennzeichnet, dass** die äußeren Metallschichten (3.2) durch Walzplattieren aufgebracht ist.

3. Trennplatte nach Anspruch 1 oder 2, **dadurch gekennzeichnet, dass** die äußeren Metallschichten (3.2) aus Stahl, wie z.B. Edelstahl oder Kohlenstoffstahl, besteht.

4. Trennplatte nach Anspruch 1 oder 2, **dadurch gekennzeichnet, dass** die äußeren Metallschichten (3.2) aus Nickel bestehen.

5. Trennplatte nach einem der Ansprüche 1 bis 4, **dadurch gekennzeichnet, dass** die Kernschicht (3.1) aus Aluminium besteht.

6. Trennplatte nach einem der Ansprüche 1 bis 4, **dadurch gekennzeichnet, dass** die Kernschicht (3.1) aus Kupfer besteht.

7. Trennplatte nach einem der Ansprüche 1 bis 6, **dadurch gekennzeichnet, dass** die Kernschicht (3.1) eine Dicke von ca. 0,35 mm aufweist.

8. Trennplatte nach einem der Ansprüche 1 bis 7, **dadurch gekennzeichnet, dass** die äußeren Metallschichten (3.2) eine Dicke von ca. 0,075 mm aufweist.

9. Trennplatte nach einem der Ansprüche 1 bis 8, **dadurch gekennzeichnet, dass** auf den äußeren Metallschichten (3.2) ein Gleitmittel (3.3), z.B. auf Olefinbasis, aufgebracht ist.

## Claims

1. A separator plate (3) for the production of printed circuit board components by pressing individual layers, which separator plate (3) includes a metallic core layer (3.1) and a coating of a metal which, compared to the metallic core layer (3.1), has a high surface hardness, **characterised in that** the coating on either side of the core layer (3.1) consists of outer metal layers (3.2) applied to the core layer by cold-cladding, the metallic core layer (3.1) being made of a metal which, compared to the two outer metal layers (3.2), has good thermal conductivity.

2. A separator plate according to claim 1, **characterised in that** the outer metal layers (3.2) are applied by roll-bonding.

3. A separator plate according to claim 1 or 2, **characterised in that** the outer metal layers (3.2) are made of steel such as, e.g., high-grade steel or carbon steel.

4. A separator plate according to claim 1 or 2, **characterised in that** the outer metal layers (3.2) are made of nickel.

5. A separator plate according to any one of claims 1 to 4, **characterised in that** the core layer (3.1) is made of aluminium.

6. A separator plate according to any one of claims 1 to 4, **characterised in that** the core layer (3.1) is made of copper.

7. A separator plate according to any one of claims 1 to 6, **characterised in that** the core layer (3.1) has a thickness of about 0.35 mm.

8. A separator plate according to any one of claims 1 to 7, **characterised in that** the outer metal layers (3.2) have a thickness of about 0.075 mm.

9. A separator plate according to any one of claims 1 to 8, **characterised in that** a lubricant (3.3), e.g. based on an olefin, is applied to the outer metal layers (3.2).

## Revendications

1. Plaque séparatrice (3) pour la fabrication de composants de cartes de circuits imprimés, avec un pressage de couches individuelles, ladite plaque séparatrice (3) présentant une couche de noyau (3.1) métallique et un revêtement formé d'un métal, qui, en comparaison de la couche de noyau (3.1) métallique, présente une grande dureté de surface, **caractérisée en ce que** le revêtement est formé sur les deux faces de la couche de noyau (3.1), à partir de couches métalliques extérieures (3.2), appliquées par plaquage à froid sur la couche de noyau, la couche de noyau (3.1) métallique étant formée d'un métal bon conducteur de chaleur par rapport aux deux couches métalliques extérieures (3.2).

2. Plaque séparatrice selon la revendication 1, **caractérisée en ce que** les couches métalliques extérieures (3.2) sont appliquées par plaquage par laminage.

3. Plaque séparatrice selon la revendication 1 ou 2, **caractérisée en ce que** les couches métalliques extérieures (3.2) sont formées d'acier, tel que par exemple d'acier spécial ou d'acier au carbone.

4. Plaque séparatrice selon la revendication 1 ou 2, **caractérisée en ce que** les couches métalliques extérieures (3.2) sont formées de nickel.

5. Plaque séparatrice selon l'une des revendications 1 à 4, **caractérisée en ce que** la couche de noyau (3.1) est formée d'aluminium.

6. Plaque séparatrice selon l'une des revendications 1 à 4, **caractérisée en ce que** la couche de noyau (3.1) est formée de cuivre.

7. Plaque séparatrice selon l'une des revendications 1 à 6, **caractérisée en ce que** la couche de noyau (3.1) présente une épaisseur d'environ 0,35 mm.

8. Plaque séparatrice selon l'une des revendications 1 à 7, **caractérisée en ce que** les couches métalliques extérieures (3.2) présentent une épaisseur d'environ 0,075 mm.

9. Plaque séparatrice selon l'une des revendications 1 à 8, **caractérisée en ce qu'**un agent glissant (3.3), par exemple à base d'oléfine, est appliqué sur les couches métalliques extérieures (3.2).
